Europäisches Patentamt

European Patent Office

Office européen des brevets

(11) Veröffentlichungsnummer: **0 264 662 B1**

# EUROPÄISCHE PATENTSCHRIFT

(45) Veröffentlichungstag der Patentschrift: **02.12.92**

(51) Int. Cl.⁵: **H03K 4/69**, H04N 3/16

(21) Anmeldenummer: **87114092.7**

(22) Anmeldetag: **26.09.87**

(54) **Schaltungsanordnung zur Erzeugung eines Ablenkstromes mit einer Anordnung zur Einleitung eines schnellen Rücklaufs.**

(30) Priorität: **04.10.86 DE 3633904**

(43) Veröffentlichungstag der Anmeldung:
**27.04.88 Patentblatt 88/17**

(45) Bekanntmachung des Hinweises auf die Patenterteilung:
**02.12.92 Patentblatt 92/49**

(84) Benannte Vertragsstaaten:
**AT BE CH DE ES FR GB IT LI LU NL**

(56) Entgegenhaltungen:
**FR-A- 2 115 406**
**US-A- 3 938 002**
**US-A- 3 983 452**
**US-A- 4 184 105**
**US-A- 4 289 994**

(73) Patentinhaber: **Deutsche Thomson-Brandt GmbH**
**Hermann-Schwer-Strasse 3 Postfach 1307**
**W-7730 Villingen-Schwenningen(DE)**

(72) Erfinder: **Lopez, Daniel**
**Forststrasse 27**
**W-7744 Königsfeld-Neuhausen(DE)**
Erfinder: **Rilly, Gerard**
**Panoramaweg 6**
**W-7731 Unterkirnach(DE)**

**Beschreibung**

Die vorliegende Erfindung betrifft eine Schaltungsanordnung zur Erzeugung eines Ablenkstromes für die Vertikalablenkung von Elektronenstrahlen in einer Bildwiedergaberöhre mit Hilfe einer den Ablenkstrom liefernden Vertikalendstufe, an deren Ausgang die Vertikalablenkspulen in Serie zu einem Koppelkondensator nach Bezugspotential geschaltet sind und mit einer Anordnung zur Einleitung eines schnellen Rücklaufs der Elektronenstrahlen, wobei an den Ausgang der Vertikalendstufe ein Kondensator geschaltet ist, dessen andere Seite einerseits an eine positive Betriebsspannung und andererseits an eine negative Betriebsspannung anlegbar ist, sowie mit einer Steuerschaltung, die während des vertikalen Rücklaufs an diesem Kondensator einen durch die positive und negative Betriebsspannung gebildeten Spannungssprung erzeugt.

Eine derartige Schaltungsanordnung ist bekannt und z.B. in dem integrierten Baustein ESM 7101 der Firma Thomson CSF enthalten. Diese Schaltung besitzt einen fly-back-Generator, der für einen schnellen vertikalen Rücklauf des Elektronenstrahls bzw. der Elektronenstrahlen in einer Farbbildröhre sorgt. Der fly-back-Generator erzeugt für die Dauer des Rücklaufs eine Rücklaufspannung, die etwa doppelt so groß ist wie die Betriebsspannung für die Vertikalendstufe.

In der US-A-4 289 994 ist eine Treiberschaltung für einen Verstärker zur Erzeugung eines Vertikalablenkstromes beschrieben, die einen fly-back-Generator besitzt. Diese Schaltung eignet sich aber nicht, wenn sie größere Amplituden- und Frequenzänderungen verarbeiten soll, was bei Monitorgeräten vorkommen kann.

In der FR-A-2 115 406 wird eine Vertikalablenkschaltung beschrieben, aus welcher aber nicht hervorgeht, wie die Rücklaufzeit exakt einstellbar gemacht werden kann.

Bei der Vertikalablenkung von Elektronenstrahlen, insbesondere in Monitoren und Datensichtgeräten, tritt das Problem auf, daß die Rücklaufzeit der Elektronenstrahlen zu lang ist, so daß es wünschenswert ist, zwecks besserer Ausnutzung des Bildschirms und der damit verbundenen Erhöhung von Informationsinhalt, bei der Wiedergabe die Rücklaufzeit auf weniger als eine Millisekunde, z.B. 300 Mikrosekunden zu reduzieren. Deshalb muß die Rücklaufspannung mindestens drei Mal höher sein als die Betriebsspannung. Mit den bisher bekannten Schaltungen ist dieses nicht möglich.

Es gibt Bildwiedergabegeräte, die mit unterschiedlichen Vertikalablenkfrequenzen arbeiten. Es handelt sich bei diesen Geräten um sogenannte Multistandardgeräte. Bei diesen müssen die Ablenkamplituden den unterschiedlichen Ablenkfrequenzen angepaßt werden. Der Spitzenwert des Ablenkstromes kann hierbei um 30% schwanken. Deshalb ist es notwendig, die Rücklaufspannung diesem Spitzenwert anzupassen, bzw. bei konstant gehaltener Rücklaufspannung die Rücklaufzeit entsprechend zu verändern.

Der Erfindung liegt die Aufgabe zugrunde, die Rücklaufzeit der Elektronenstrahlen derart zu verkürzen, daß eine optimale Wiedergabe von Videosignalen, insbesondere bei Monitorgeräten sowie Multistandardgeräten oder bei Datensichtgeräten ermöglicht wird. Diese Aufgabe wird durch die im Patentanspruch 1 angegebene Erfindung gelöst.

Nachstehend wird die Erfindung an einem Ausführungsbeispiel mit Hilfe der Zeichnung erläutert.

Figur 1     zeigt die Erfindung in einem Schaltbild

Figur 2     zeigt Spannungsdiagramme zur Erläuterung der Wirkungsweise der Schaltung nach Figur 1.

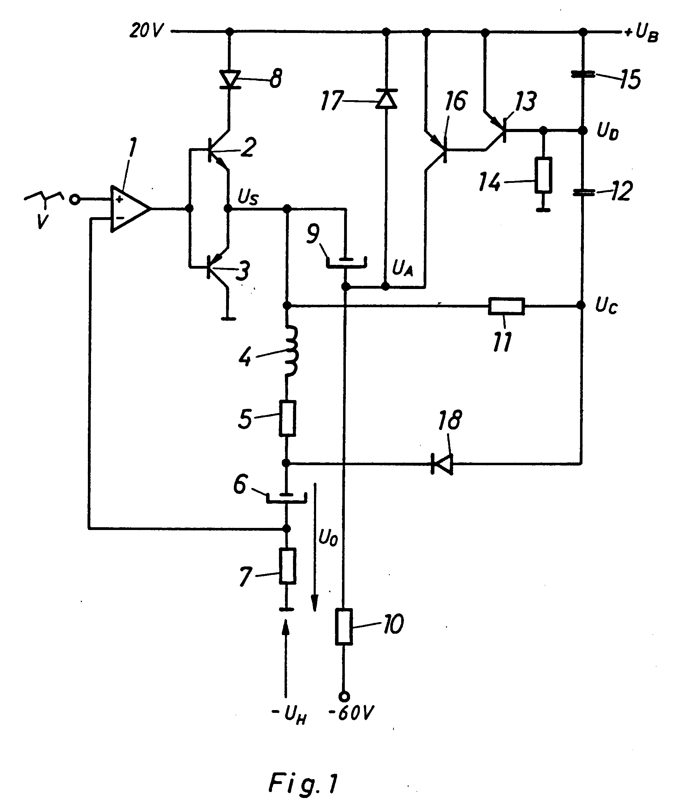

In Figur 1 ist an den positiven Eingang eines Vorverstärkers 1 das Ablenksignal V gelegt, welcher eine aus zwei komplementären Transistoren 2 und 3 bestehende Vertikalendstufe ansteuert. An den Ausgang dieser Vertikalendstufe sind die Vertikalablenkspule 4 mit ihrem Wirkwiderstand 5 in Serie zu einem Koppelkondensator 6 über einen Meßwiderstand 7 auf das Bezugspotential geschaltet. Von dem Meßwiderstand 7 wird eine dem Ablenkstrom proportionale Gegenkopplungsspannung abgegriffen, die auf den negativen Eingang des Vorverstärkers 1 gelegt ist. Die Vertikalendstufe 2,3 ist über eine Diode 8 an die positive Betriebsspannung von z.B. 20V angeschlossen. Die soweit beschriebene Ablenkschaltung ist bekannt.

Um die der Erfindung zugrunde liegende Aufgabe zu lösen, die Rücklaufzeit der Elektronenstrahlen wesentlich zu verkürzen, ist an den Ausgang der Vertikalendstufe 2, 3 ein Kondensator 9 über einen Widerstand 10 auf eine hohe negative Hilfsspannung $-U_H$ von z.B. -60V geschaltet. Der Kondensator 9 ist groß und besitzt einen Wert von etwa 100 $\mu$F und der Widerstand 10 einen Wert von 1 kOhm, so daß der Kondensator 9 während einer Ablenkperiode praktisch nicht entladen wird. An den Ausgang der Vertikalendstufe ist außerdem über einen Widerstand 11 und einen Kondensator 12 die Steuerelektrode eines elektronischen Schalters gelegt, die über den Widerstand 14 mit dem Bezugspotential und über einen weiteren Kondensator 15 mit der positiven Betriebsspannung $+U_B$ verbunden ist. Der elektronische Schalter 13 in Gestalt eines Transistors legt die positive Betriebsspannung $+U_B$ an die Steuerelektrode eines weiteren elektronischen Schalters 16, der die positive Betriebsspannung im durchgeschalteten Zustand an die Seite des Kondensators legt, die nicht mit dem Ausgang der Vertikalendstufe verbunden ist.

Eine Diode 17 parallel zum elektronischen Schalter 16 bildet mit diesem einen bipolaren Schalter und dient dazu, daß der Ablenkstrom während des Rücklaufs, in der Zeit des Sperrzustandes des elektronischen Schalters 16, zur positiven Betriebsspannung $+U_B$ fließen kann.

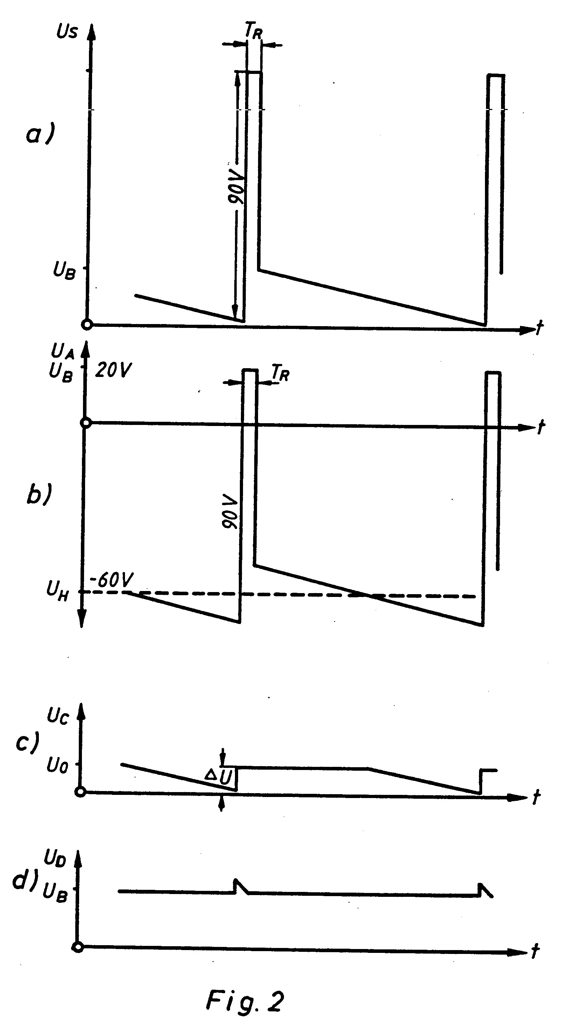

Nachfolgend wird die Wirkungsweise der Schaltungsanordnung in Verbindung mit den Diagrammen nach Figur 2 beschrieben. Während des gesamten Hinlaufs der Ablenkung ist der elektronische Schalter 13 durchgeschaltet, so daß der elektronische Schalter 16 gesperrt ist. Die Spannung $U_s$ am Ausgang der Vertikalendstufe sinkt von nahezu Betriebsspannung $+U_s$ auf einen Wert $U_{smin}$ (Figur 2a). Solange wie die Spannung $U_s$ größer als die Spannung $U_o$ am Kondensator 6 ist, bleibt die Spannung $U_c$ am Widerstand 11 über die leitende Diode 18 auf der Spannung $U_o$ ungefähr auf $U_B/2$ geklemmt. Ab Mitte der Ablenkung sinkt die Spannung $U_s$ unter diesen Wert, so daß auch die Spannung $U_c$ bis zu einem Minimalwert $U_{smin}$ absinkt (Figur 2c). Bei Einleiten des Rücklaufs wird der positive Spannungssprung von $U_c$ über den kapazitiven Spannungsteiler 12, 15 auf die Steuerelektrode des elektronischen Schalters 13 übertragen. Dieser positive Spannungssprung beträgt $U = R_v * I_{pp}$, wobei $R_v$ den ohmschen Widerstandswert 5 der Vertikalablenkwicklung 4 und $I_{pp}$ den Spitze-Spitze-Wert des Ablenkstromes darstellt. Der positive Spannungssprung wird durch den kapazitiven Spannungsteiler derart auf die Steuerelektrode des elektronischen Schalters 13 übertragen, daß die Schwelle der Zener-Spannung der Basis-Emitter-Strecke nicht überschritten wird (Figur 2d). Dadurch wird der elektronische Schalter 13 gesperrt und durch die aus dem Widerstand 14 und den Kondensatoren 12 und 15 gebildeten Zeitkonstante in diesem Zustand gehalten. An der Basis des elektronischen Schalters 13 entsteht ein Spannungssprung $U_D$ der damit proportional zum Spitzenstrom $I_{pp}$ ist. Die Zeit des gesperrten Zustandes des elektronischen Schalters 13 wird durch die Zeitkonstante bestimmt, so daß die Rücklaufzeit der Vertikalablenkung $T_R$ proportional zur Spannung $U_D$ und zum Spitzenstrom $I_{pp}$ beeinflussbar ist. Der Wert des Widerstandes 14 wird in Abhängigkeit von der Induktivität der Ablenkwicklung 4, der Höhe der Hilfsspannung $U_H$ und der gewünschten Rücklaufzeit $T_R$ gewählt. Durch das Sperren des elektronischen Schalters 13 zu Beginn des Rücklaufs wird der elektronische Schalter 16 leitend und schaltet die positive Betriebsspannung $+U_s$ auf den Kondensator 9 (Figur 2b). Da der Kondensator 9 seine Ladung nicht verliert, erhöht sich das zuvor auf nahezu 0 V gelegene Potential $U_s$ auf einen Wert von $+90V$. Diese hohe Spannungsspitze bewirkt eine wesentlich kürzere Rücklaufzeit, da diese Spannung etwa drei mal größer als die Betriebsspannung $U_s$ ist.

Für den Fall, daß die Vertikalablenkfrequenz unterschiedlich ist, muß die Vertikalablenkamplitude dieser Frequenz angepasst sein. Der Ablenkstrom kann sich um 30 % ändern, so daß die Rücklaufspannung $U_R$ dem Ablenkstrom proportional ist. Bei konstant gehaltener Rücklaufspannung muß die Rücklaufzeit $T_R$ entsprechend proportional zum Ablenkspitzenstrom verändert werden.

## Patentansprüche

1. Schaltungsanordnung zur Erzeugung eines Ablenkstromes für die Vertikalablenkung von Elektronenstrahlen in einer Bildwiedergaberöhre mit Hilfe einer den Ablenkstrom liefernden Vertikalendstufe (2, 3), an deren Ausgang die Vertikalablenkspulen (4) in Serie zu einem Koppelkondensator (6) nach Bezugspotential geschaltet sind, mit einer Anordnung zur Einleitung eines schnellen Rücklaufs der Elektronenstrahlen, wobei an den Ausgang der Vertikalendstufe (2, 3) ein Kondensator (9) geschaltet ist, dessen andere Seite einerseits an eine positive Betriebsspannung und andererseits an eine negative Betriebsspannung anlegbar ist, sowie mit einer Steuerschaltung, die während des vertikalen Rücklaufs an diesem Kondensator (9) einen durch die positive und negative Betriebsspannung gebildeten Spannungssprung erzeugt, **dadurch gekennzeichnet,** daß die dem Ausgang der Vertikalendstufe (2, 3) abgewandte Seite des Kondensators (9) mit einer Hilfsspannungsquelle ($-U_H$) verbunden ist, welche die negative Betriebsspannung liefert, daß an den Koppelkondensator (6) die Katode einer Diode (18) geschaltet ist und daß an den Ausgang der Vertikalendstufe (2, 3) ein Widerstand (11) geschaltet ist und daß der Widerstand (11) und die Anode der Diode (18) zusammen an den Eingang der Steuerschaltung geschaltet sind, die aus einem Differenzierglied (12,14) besteht, das Teil eines kapazitiven Spannungsteilers (12,15) ist und daß das Differenzierglied (12, 14) mit einem während des vertikalen Hinlaufs durchgeschalteten elektronischen Schalter (13) verbunden ist, der bei Einleiten des vertikalen Rücklaufs gesperrt wird, wobei der elektronische Schalter (13) mit einem zweiten elektronischen Schalter (16) verbunden ist, der während der Sperrphase des ersten elektronischen Schalters (13) die positive Betriebsspannung ($+U_B$) an die mit der negativen Hifsspannungsquelle ($-U_H$) verbundene Seite des Kondensators (9) schaltet, wobei die Steuerschaltung die Dauer der Zuführung der positiven Betriebsspannung ($+U_B$)

in Abhängigkeit von dem Spitzenwert ($I_{pp}$) des Ablenkstromes steuert.

**2.** Schaltungsanordnung nach Anspruch 1, **dadurch gekennzeichnet,** daß die negative Betriebsspannung ($-U_H$) im Betrag mindestens drei mal so groß ist wie die positive Betriebsspannung ($+U_B$) für die Vertikalendstufe.

## Claims

**1.** Circuit arrangement for the production of a deflection current for the vertical deflection of electron beams in a picture reproducing tube with the help of a vertical output stage (2, 3) delivering the deflection current, at whose output, the vertical deflection coil (4) in series with a coupling capacitor (6) are connected to reference potential, with an arrangement for the initiation of a rapid fly back of the electron beams, wherein there is connected to the output of the vertical output stage (2, 3) a capacitor (9) whose other side is connectable on the one hand to a positive operating voltage and on the other hand to a negative operating voltage, as well as with a control circuit which generates on this capacitor (9) during the vertical flyback a voltage jump developed by the positive and negative operating voltage, characterised in that, the side of the capacitor (9) facing away from the output of the vertical output stage (2, 3) is connected to an auxiliary voltage source ($-U_H$), which delivers the negative operating voltage, that the cathode of a diode (18) is connected to the coupling capacitor (6) and that a resistor (11) is connected to the output of the vertical output stage (2, 3) and that the resistor (11) and the anode of the diode (18) are connected together to the input of the control circuit which consists of a differentiating member (12, 14) which is a part of a capacitive voltage divider (12, 15) and that the differentiating member (12, 14) is connected to an electronic switch (13) that is switched through during the vertical run, which is blocked at the initiation of the vertical fly back, wherein the electronic switch (13) is connected to a second electronic switch (16) which, during the blocked phase of the first electronic switch (13), switches the positive operating voltage ($+U_B$) to the side of the capacitor (9) connected to the negative auxiliary voltage source ($-U_H$), wherein the control circuit controls the duration of the supply of the positive operating voltage ($+U_B$) in dependence on the peak value ($I_{pp}$) of the deflection current.

**2.** Switching arrangement in accordance with claim 1, characterised in that, the negative operating voltage ($-U_H$) is at least three times as great in value as the positive operating voltage ($+U_B$) for the vertical output stage.

## Revendications

**1.** Dispositif de circuitpour produire un courant de balayage pour le balayage vertical de faisceaux électroniques dans un tube image à l'aide d'un étage de sortie verticale (2, 3), qui délivre le courant de balayage, à la sortie duquel les bobines de balayage vertical (4) sont montées en série avec un condensateur de liaison (6) sur le potentiel de référence, avec un dispositif pour introduire un retour rapide des faisceaux électroniques, un condensateur (9) étant commuté à la sortie de l'étage de sortie verticale (2, 3), condensateur dont l'autre côté peut être appliqué d'une part à une tension de fonctionnement positive et d'autre part à une tension de fonctionnement négative, ainsi qu'avec un circuit de commande qui produit un saut de tension formé par la tension de fonctionnement positive et négative sur ce condensateur (9) pendant le retour vertical,

**caractérisé en ce**

que le côté du condensateur (9), qui est opposé à la sortie de l'étage de sortie verticale (2, 3), est relié à une source de tension auxiliaire ($-U_H$) qui donne la tension de fonctionnement négative, que la cathode d'une diode (18) est commutée sur le condensateur de liaison (6) et qu'une résistance (11) est commutée sur la sortie de l'étage de sortie verticale (2, 3) et que la résistance (11) et l'anode de la diode (18) sont commutées ensemble à l'entrée du circuit de commande qui est composé d'un élément différenciateur (12, 14) qui fait partie d'un diviseur de tension capacitif (12, 15) et que l'élément différenciateur (12, 14) est relié à un commutateur électronique (13), connecté pendant l'aller vertical, qui est bloqué lors de l'introduction du retour vertical, le commutateur électronique (13) étant relié à un second commutateur électronique (16) qui commute, pendant la phase de blocage du premier commutateur électronique (13), la tension de fonctionnement positive ($+U_B$) sur le côté du condensateur (9) qui est relié à la source de tension auxiliaire négative ($-U_H$), le circuit de commande commandant la durée de l'amenée de la tension de fonctionnement positive ($+U_B$) en fonction de la valeur de crête ($I_{pp}$) du courant de balayage.

2. Dispositif de circuit selon la revendication 1, **caractérisé en ce** que la tension de fonctionnement négative ($-U_H$) est de valeur au moins trois fois égale à la tension de fonctionnement positive ($+U_B$) pour l'étage de sortie verticale.

*Fig.1*

*Fig. 2*